# EUROPÄISCHE PATENTSCHRIFT

(11) **EP 2 569 832 B1**
(45) Veröffentlichungstag und Bekanntmachung des Hinweises auf die Patenterteilung: **11.12.2019**
(21) Anmeldenummer: 11724985.4
(22) Anmeldetag: 09.05.2011
(51) Int. Cl.: H01S 5/042, H01S 5/0625, H01S 5/40

(54) **KANTENEMITTIERENDER HALBLEITERLASER**
EDGE-EMITTING SEMICONDUCTOR LASER
LASER À SEMI-CONDUCTEURS À ÉMISSION LATÉRALE

(30) Priorität: 14.05.2010 DE 102010020625
(43) Veröffentlichungstag der Anmeldung: 20.03.2013
(73) Patentinhaber: OSRAM Opto Semiconductors GmbH, 93055 Regensburg (DE)
(72) Erfinder: KÖNIG, Harald, 93170 Bernhardswald (DE); STRAUSS, Uwe, 93077 Bad Abbach (DE); REILL, Wolfgang, 93080 Pentling (DE)
(74) Vertreter: Epping - Hermann - Fischer
(86) Internationale Anmeldenummer: PCT/EP2011/057415
(87) Internationale Veröffentlichungsnummer: WO 2011/141421

(56) Entgegenhaltungen:
- EP-A1- 1 710 876
- EP-A2- 1 460 742
- EP-A2- 1 713 150
- DE-A1- 19 708 385
- JP-A- 1 251 686
- JP-A- H01 251 686
- US-A- 5 561 682
- US-A1- 2009 310 630
- STAREEV G: "FORMATION OF EXTREMELY LOW RESISTANCE TI/PT/AU OHMIC CONTACTS TO P-GAAS", APPLIED PHYSICS LETTERS, A I P PUBLISHING LLC, US, vol. 62, no. 22, 31 May 1993 (1993-05-31), pages 2801-2803, XP000380907, ISSN: 0003-6951, DOI: 10.1063/1.109214

## Beschreibung

Es werden ein kantenemittierender Halbleiterlaser sowie ein Verfahren zur Herstellung eines kantenemittierenden Halbleiterlasers angegeben.

Diese Patentanmeldung beansprucht die Priorität der deutschen Patentanmeldung mit der Nummer 10 2010 020 625.3.

Eine zu lösende Aufgabe besteht darin, einen kantenemittierenden Halbleiterlaser anzugeben, dessen optische Ausgangsleistung einstellbar ist. Eine weitere zu lösende Aufgabe besteht darin, ein effizientes und einfaches Verfahren zur Herstellung eines kantenemittierenden Halbleiterlasers anzugeben.

Die Druckschrift EP 1710876 A1 betrifft ein Halbleiterlaserbauteil und einen Laserprojektor.

Die Druckschrift US 5,561,682 betrifft ein optisches Halbleiterbauelement und ein optisches Kommunikationsmodul.

Die Druckschrift EP 1713150 A2 betrifft ein optisches Halbleiterbauelement und ein Verfahren zur Steuerung eines optischen Halbleiterbauelements.

Die Druckschrift DE 19708385 A1 betrifft ein wellenlängenabstimmbares optoelektronisches Bauelement.

Die Druckschrift EP 1460742 A2 betrifft einen optischen Halbleiterverstärker.

Die Druckschrift US 2009/0310630 betrifft einen Halbleiterlaser mit mehreren benachbarten Kontaktstellen.

Gemäß zumindest einer Ausführungsform des kantenemittierenden Halbleiterlasers umfasst dieser einen Halbleiterkörper, der zumindest eine zur Erzeugung von elektromagnetischer Strahlung geeignete aktive Zone umfasst. Beispielsweise ist der Halbleiterkörper mit einem Substrat gebildet, auf das eine Halbleiterschichtenfolge epitaktisch aufgewachsen ist. Der Halbleiterkörper kann auch mehrere aktive Zonen umfassen, die in vertikaler Richtung übereinander angeordnet sind. "Vertikale Richtung" bedeutet in diesem Zusammenhang eine Richtung senkrecht zur epitaktisch gewachsenen Halbleiterschichtenfolge. Die aktiven Zonen sind dann "stapelförmig" übereinander angeordnet und können dann eine "gestapelte" Laserstruktur ausbilden.

Bei der aktiven Zone kann es sich um eine Schicht handeln, die Strahlung im Bereich von ultraviolettem bis infrarotem Licht emittiert. Die aktive Zone umfasst bevorzugt einen pn-Übergang, eine Doppelheterostruktur, einen Einfachquantentopf- (SQW, single quantum well) oder eine Mehrfachquantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen.

Gemäß zumindest einer Ausführungsform des kantenemittierenden Halbleiterlasers weist dieser zumindest zwei Facetten an der aktiven Zone auf, die einen Resonator bilden. Unter Facette ist hierbei eine glatte Grenzfläche zu verstehen. "Glatt" bedeutet hierbei, dass die Oberflächenrauheit der Facette, insbesondere im Bereich der aktiven Zone und der Wellenführung, deutlich kleiner ist als die Wellenlänge des von dem kantenemittierenden Halbleiterlasers in dessen Betrieb zu erzeugenden Lichts, bevorzugt kleiner als die Hälfte der Wellenlänge, besonders bevorzugt kleiner als ein Viertel der Wellenlänge. Die zumindest zwei Facetten verlaufen in vertikaler Richtung und begrenzen die aktive Zone daher in lateraler Richtung, also in einer Emissionsrichtung des Halbleiterlasers. Mit anderen Worten ist die aktive Zone in lateraler Richtung zwischen den zumindest zwei Facetten angeordnet. Die Facetten bilden Seitenflächen des Halbleiterkörpers des kantenemittierenden Halbleiterlasers. "Laterale Richtung" bedeutet hierbei, eine Richtung parallel zur epitaktisch gewachsenen Halbleiterschichtenfolge. Vorzugsweise liegen die zwei Facetten des kantenemittierenden Halbleiterlasers an einander gegenüberliegenden Seiten des Halbleiterkörpers. Ist der Halbleiterlaser beispielsweise von Luft oder einem anderen Material mit niedrigerem optischen Brechungsindex als der Brechungsindex der aktiven Zone umgeben, so kann die von der aktiven Zone erzeugte elektromagnetische Strahlung an der Grenzfläche Facette/Luft teilweise reflektiert werden. Liegen sich nun die zwei Facetten an einander gegenüberliegenden Seiten des Halbleiterkörpers, so bilden die beiden Facetten einen optischen Resonator. Vorzugsweise verläuft die laterale Richtung parallel zu einer durch die Facetten ausgebildeten Resonatorachse des Resonators. Über zumindest eine der Facetten kann dann ein Teil von der aktiven Zone erzeugte elektromagnetische Strahlung aus dem Halbleiterlaser ausgekoppelt werden.

Gemäß zumindest einer Ausführungsform des kantenemittierenden Halbleiterlasers umfasst dieser zumindest zwei in lateraler Richtung voneinander durch zumindest einen Zwischenbereich beabstandete Kontaktstellen, die auf einer Außenfläche des Halbleiterkörpers angebracht sind. Vorzugsweise sind die Kontaktstellen an der gleichen Seite des Halbleiterkörpers angeordnet. In einer Draufsicht auf den kantenemittierenden Halbleiterlaser ist der Zwischenbereich durch zwei jeweils in lateraler Richtung aneinander angrenzende Kontaktstellen und beispielsweise der den Kontaktstellen zugewandten Außenfläche des Halbleiterkörpers begrenzt. Mit anderen Worten sind die Kontaktstellen durch einen Zwischenbereich jeweils voneinander getrennt. In lateraler Richtung zwischen den Facetten des kantenemittierenden Halbleiterlasers befinden sich also die in lateraler Richtung voneinander getrennten Zwischenbereiche. Beispielsweise sind auf der Außenfläche zwei, vier, acht oder mehr Kontaktstellen angeordnet. Mit anderen Worten bestimmt die Anzahl der Kontaktstellen in lateraler Richtung eine Resonatorlänge des Resonators.

Die Kontaktstellen dienen zur elektrischen Kontaktierung des Halbleiterlasers und bilden unter externer elektrischer Kontaktierung vorzugsweise einen elektrischen Kontakt des gleichen elektrischen Potentials aus. Zum Beispiel sind die Kontaktstellen ein Pluspol des kantenemittierenden Halbleiterlasers. Zur elektrischen Kontaktierung können die Kontaktstellen in direktem Kontakt mit dem Halbleiterkörper stehen. Beispielsweise sind die Zwischenbereiche nicht elektrisch leitend oder kontaktierbar ausgebildet.

Vorzugsweise wechseln sich Zwischenbereiche und Kontaktstellen über die gesamte Länge des Resonators ab, so dass eine Strukturierung des Anschlussbereichs des Lasers auch in der Mitte des Resonators in Kontaktstellen und Zwischenbereiche erfolgt.

Zum Beispiel weisen die Kontaktstellen in einer Draufsicht auf den Halbleiterlaser jeweils die gleiche geometrische Grundform auf. Denkbar ist, dass die Kontaktstellen rechteckförmig, quadratisch, oval, kreisförmig oder ellipsoid ausgeformt sind. Die Kanten der Kontaktstellen können dabei weitere, kleinere Strukturen aufweisen.

Gemäß zumindest einer Ausführungsform des kantenemittierenden Halbleiterlasers weist der Halbleiterlaser einen Halbleiterkörper auf, wobei der Halbleiterkörper zumindest eine zur Erzeugung von elektromagnetischer Strahlung geeignete aktive Zone umfasst. Weiter weist der Halbleiterlaser zumindest zwei Facetten an der aktiven Zone auf, die einen Resonator bilden. Zumindest zwei in lateraler Richtung voneinander durch zumindest einen Zwischenbereich beabstandete Kontaktstellen sind auf einer Außenfläche des Halbleiterkörpers angebracht.

Der hier beschriebene kantenemittierende Halbleiterlaser beruht dabei unter anderem auf der Erkenntnis, dass eine Ausgangsleistung durch die Anordnung und äußere Beschaffenheit von Kontaktstellen des Halbleiterlasers bestimmt sein kann. Ist beispielsweise ein kantenemittierender Halbleiterlaser über eine einzige, in lateraler Richtung, durchgehende und zusammenhängende Kontaktstelle elektrisch kontaktiert, so hat dies den Nachteil, dass eine sich zwischen einer solchen Kontaktstelle und einem Halbleiterkörper des Halbleiterlasers ausbildende Kontaktfläche nur vollständig, das heißt über die gesamte Ausdehnung einer solchen Kontaktfläche, elektrisch kontaktiert werden kann. Verläuft eine solche Kontaktstelle durchgehend zwischen zwei einen Resonator des Halbleiterlasers ausbildenden Facetten, so kann durch eine derartige Kontaktstelle die aktive Zone des Halbleiterlasers nicht über die Größe und Aufbau der Kontaktfläche individuell bestromt werden. Die optische Ausgangsleistung des kantenemittierenden Halbleiterlasers ist daher über die einzige elektrische Kontaktstelle lediglich beispielsweise in einer absoluten Bestromungs- beziehungsweise Spannungshöhe regelbar.

Um nun die optische Ausgangsleistung und Appatur des Halbleiterlasers individuell einstellen und anpassen zu können, macht der hier beschriebene Halbleiterlaser von der Idee Gebrauch, zumindest zwei in lateraler Richtung voneinander durch zumindest einen Zwischenbereich beabstandete Kontaktstellen auf einer Außenfläche des Halbleiterkörpers anzubringen. Je nach individuellem Bedarf können nun eine, mehrere oder alle der in lateraler Richtung voneinander beabstandet angeordneten Kontaktstellen extern elektrisch kontaktiert werden. Je nach Anzahl beziehungsweise Anordnung der elektrisch kontaktierten Kontaktstellen kann so die aktive Zone individuell bestromt werden, wodurch ebenso die optische Ausgangsleistung den jeweiligen Bedürfnissen über die Größe und/oder der Ausdehnung der Kontaktfläche angepasst werden kann.

Gemäß zumindest einer Ausführungsform sind die Kontaktstellen unabhängig voneinander kontaktier- und/oder bestrombar. Vorteilhaft können nicht nur eine vorgebbare Anzahl von Kontaktstellen bestromt und kontaktiert werden, es kann durch die unabhängige Bestrombarkeit auch jede der Kontaktstellen mit unterschiedlichen Stromstärken bestromt werden. Insofern sind unterschiedliche Stromstärken, die sich im Halbleiterkörper überlagern können, mit unterschiedlichen Kontaktierungsmustern kombinierbar.

Gemäß zumindest einer Ausführungsform weist der kantenemittierende Halbleiterlaser eine Vielzahl von matrixartig angeordneten Kontaktstellen auf, die auf der Außenfläche des Halbleiterkörpers angebracht sind und sowohl in lateraler Richtung als auch in einer zur lateralen Richtung quer verlaufenden Querrichtung jeweils durch Zwischenbereiche voneinander beabstandet angeordnet sind.

"Matrixartig" bedeutet in diesem Zusammenhang, dass die Vielzahl der Kontaktstellen vorzugsweise in Form von Zeilen und Spalten auf der Außenfläche des Halbleiterkörpers angebracht sind. Dabei müssen die Kontaktstellen nicht zwingend in einem regelmäßigen Gitter auf der Außenfläche des Halbleiterkörpers aufgebracht sein.

Sowohl die laterale Richtung als auch die zur lateralen Richtung quer verlaufende Querrichtung liegen in einer gemeinsamen Ebene, die parallel zur epitaktisch gewachsenen Halbleiterschichtenfolge verläuft. Ebenso wie die Zwischenbereiche, die die Kontaktstellen in lateraler Richtung voneinander beabstanden, sind diejenigen Zwischenbereiche, die die Kontaktstellen in der Querrichtung voneinander beabstanden, in einer Draufsicht auf die Außenfläche des Halbleiterkörpers, beispielsweise durch Seitenflächen zweier jeweils in Querrichtung aneinander angrenzender Kontaktstellen und der den Kontaktstellen zugewandten Außenfläche des Halbleiterkörpers begrenzt. Beispielsweise sind die Kontaktstellen in einer 2x2, 4x4, 8x8 oder größeren Matrix angeordnet. Mit anderen Worten bestimmt die Anzahl der Kontaktstellen in Querrichtung eine Breite des Halbleiterkörpers und damit der aktiven Zone. Die Anzahl der in Querrichtung angeordneten Kontaktstellen kann daher eine Emissionsfläche und somit ebenso eine optische Ausgangsleistung festlegen beziehungsweise modulieren. Denkbar ist in diesem Zusammenhang, dass sowohl in lateraler als auch in Querrichtung nur jede zweite Kontaktstelle elektrisch kontaktiert ist. Ebenso sind auch beliebige andere Kontaktierungsmuster, die je nach Bedarf verändert werden können, denkbar.

Gemäß zumindest einer Ausführungsform ist zumindest ein Strukturierungsgraben im Bereich zwischen in Querrichtung benachbarten Kontaktstellen in den Halbleiterkörper eingebracht, wobei im Bereich des Strukturierungsgrabens Teile des Halbleiterkörpers zumindest stellenweise vollständig entfernt sind und der Strukturierungsgraben in vertikaler Richtung nicht bis zur aktiven Zone reicht. Beispielsweise verläuft der Strukturierungsgraben durchgehend und zusammenhängend in lateraler Richtung zwischen den beiden Facetten. Mit anderen Worten bildet der Strukturierungsgraben dann ein zusammenhängendes Gebiet aus. Insbesondere weist der zumindest eine Strukturierungsgraben eine einer Öffnung des Strukturierungsgrabens gegenüberliegende Bodenfläche sowie zwei Seitenflächen auf, welche durch die Bodenfläche miteinander verbunden sind. Sowohl die Seitenflächen als auch die Bodenfläche sind dann vollständig durch die Halbleiterschichtenfolge gebildet. Es handelt sich bei dem Strukturierungsgraben also zum Beispiel um eine Ausnehmung in der Halbleiterschichtenfolge. Vorzugsweise sind die Kontaktelemente in Querrichtung beidseitig von jeweils einem oder mehreren Strukturierungsgräben benachbart. Mit anderen Worten können dann die lateral angeordneten Kontaktelemente und die beiden Strukturierungsgräben parallel zueinander verlaufen. Durch die in Querrichtung beidseitig neben den Kontaktelementen angeordneten Strukturierungsgräben ist also ein Breitstreifenlaser oder Rippenlaser (ridge laser) ausgebildet. Eine Rippenbreite, also die Ausdehnung des Halbleiterkörpers in Querrichtung direkt unterhalb den Kontaktelementen, ist dann eine jeweilige Rippenbreite des Halbleiterlasers.

Da der Strukturierungsgraben in vertikaler Richtung nicht bis zur aktiven Zone reicht, unterbricht der Strukturierungsgraben die aktive Zone nicht, sondern strukturiert lediglich das zwischen den Kontaktflächen und der aktiven Zone liegende Halbleitermaterial des Halbleiterkörpers.

Gemäß zumindest einer Ausführungsform umfasst der kantenemittierende Halbleiterlaser zumindest einen weiteren Graben, der zwischen zumindest zwei Blöcken mit jeweils mehreren, in Querrichtung benachbarten, Kontaktstellen angeordnet ist. Der weitere Graben weist vorzugsweise eine Dicke von wenigstens 30pm auf.

Gemäß zumindest einer Ausführungsform sind unter externer Bestromung zumindest zweier in lateraler Richtung benachbarter Kontaktstellen mit den Kontaktstellen in vertikaler Richtung nicht überlappende Bereiche der aktiven Zone zumindest mit dem 0,3-Fachen einer maximalen Bestromungsdichte jmax der aktiven Zone bestromt. Vorzugsweise liegt die Bestromungsdichte innerhalb der nicht überlappenden Bereiche oberhalb einer Laseranregungsschwelle (auch Threshold-Schwelle) der aktiven Zone. Eine derartige Mindestbestromungsdichte der mit den Kontaktstellen in vertikaler Richtung nicht überlappenden Bereiche der aktiven Zone stellt sicher, dass die aktive Zone in lateraler Richtung weder Bestromungslücken noch beispielsweise abrupte Bestromungsdichtenunterschiede entlang der aktiven Zone aufweist. Mit anderen Worten erlauben zwar die in lateraler Richtung beabstandeten Kontaktstellen eine Einstellung eines Bestromungsprofils, welches vorzugsweise jedoch kontinuierlich, das heißt ohne Stufen oder Unterbrechungen, in lateraler Richtung verläuft.

Gemäß zumindest einer Ausführungsform ist ein Abstand zweier in lateraler Richtung benachbarter Kontaktstellen höchstens eine maximale laterale Ausdehnung der Kontaktstellen.. "Maximale laterale Ausdehnung" bedeutet in diesem Zusammenhang, die maximale Ausdehnung der Kontaktstellen in lateraler Richtung. Durch einen derartig gewählten Höchstabstand der Kontaktstellen wird es ermöglicht, dass eine zur Bestromung der aktiven Zone ausreichende Kontaktfläche der Kontaktstellen zur Bestromung der aktiven Zone zur Verfügung steht.

Gemäß zumindest einer Ausführungsform sind die Kontaktstellen in lateraler Richtung im gleichen und/oder regelmäßigen Abstand auf der Außenfläche des Halbleiterkörpers zueinander angeordnet. Das kann heißen, dass der Abstand der Zwischenbereiche über die gesamte laterale Ausdehnung des Halbleiterköpers konstant ist.

Gemäß zumindest einer Ausführungsform sind die Kontaktstellen mit einem sich in lateraler Richtung periodisch ändernden Abstand auf der Außenfläche des Halbleiterkörpers angeordnet. Zum Beispiel wechseln sich zwei unterschiedlich große Abstände in lateraler Richtung gegenseitig ab.

Gemäß zumindest einer Ausführungsform ist die maximale laterale Ausdehnung der Kontaktstellen konstant. Sind die Kontaktstellen beispielsweise rechteckförmig, ist zumindest eine Kantenlänge der Kontaktstellen, welche parallel zur lateralen Richtung verläuft, bei jedem der Kontaktstellen gleich. Ferner können die Kontaktstellen in weiteren oder allen geometrischen Abmessungen jeweils identisch sein. Beispielsweise können alle Kontaktstellen in einer Draufsicht den gleichen Flächeninhalt haben.

Gemäß zumindest einer Ausführungsform des kantenemittierenden Halbleiterlasers ist in vertikaler Richtung zwischen den Kontaktstellen und dem Halbleiterkörper zumindest stellenweise eine ohmsche Kontaktschicht angeordnet. Die ohmsche Kontaktschicht dient zur elektrischen Kontaktierung der Kontaktstellen mit dem Halbleiterkörper. Vorzugsweise ist die ohmsche Kontaktschicht mit einem metallischen Material gebildet. Beispielsweise ist die ohmsche Kontaktschicht auf die Außenfläche des Halbleiterkörpers aufgebracht. Der durch die ohmsche Kontaktschicht ausgebildete elektrische Widerstand ermöglicht daher eine elektrische Kontaktierung der Kontaktstellen mit dem Halbleiterkörper.

Gemäß zumindest einer Ausführungsform ist eine maximale vertikale Ausdehnung bei jeder der Kontaktstellen in lateraler Richtung konstant. "Maximale vertikale Ausdehnung" bedeutet in diesem Zusammenhang, die maximale Ausdehnung der Kontaktstellen in vertikaler Richtung. Denkbar ist dann, dass die Kontaktstellen in allen geometrischen Abmessungen miteinander identisch sind. Beispielsweise sind die Kontaktstellen quaderförmig oder kubisch ausgeformt.

Gemäß zumindest einer Ausführungsform enthält die ohmsche Kontaktschicht zumindest eines der Materialien Ti, Cr, Pt, Pd. Die genannten Materialien haben sich als ganz besonders vorteilhaft für die Ausbildung einer ohmschen Kontaktschicht beziehungsweise eines elektrischen Widerstands zwischen den Kontaktstellen und dem Halbleiterkörper erwiesen.

Gemäß zumindest einer Ausführungsform ist auf die ohmsche Kontaktschicht zumindest stellenweise eine Benetzungsschicht aufgebracht. Beispielsweise ist die Benetzungsschicht auf die gesamte ohmsche Kontaktschicht aufgebracht. Ferner kann die Benetzungsschicht auch direkt auf das Halbleitermaterial des Halbleiterkörpers, zum Beispiel im Bereich der Zwischenbereiche, aufgebracht werden. An diesen Stellen befindet sich dann beispielsweise zwischen der Benetzungsschicht und dem Halbleiterkörper keine ohmsche Kontaktschicht. Die Benetzungsschicht kann mit Silber und/oder Gold gebildet sein. Ebenso ist denkbar, dass die Benetzungsschicht mit weiteren metallischen Materialien und/oder elektrisch leitenden Materialien gebildet ist. Vorteilhaft ermöglicht die Benetzungsschicht eine Benetzung mit einem Lotmaterial, sodass auf die Benetzungsschicht mittels des Lotmaterials die Kontaktstellen mechanisch fest aufgelötet werden können.

Gemäß zumindest einer Ausführungsform beträgt eine Dicke der Benetzungsschicht höchstens ein Viertel, bevorzugt höchstens ein Zehntel, der maximalen vertikalen Ausdehnung der Kontaktstellen.

Die Summe der Dicken von ohmscher Kontaktschicht und Benetzungsschicht ist vorzugsweise höchstens 1µm, zum Beispiel 500 nm.

Gemäß zumindest einer Ausführungsform ist auf zumindest einer Facette zumindest stellenweise zumindest eine Passivierungsschicht aufgebracht, die zumindest eines der Materialien Siliziumdioxid, Siliziumnitrid, Titandioxid, Aluminiumdioxid, Silizium enthält. Das heißt, dass die Passivierungsschicht in direktem Kontakt mit der Facette steht. Beispielsweise wird auf die eine Facette des Halbleiterkörpers eine Passivierungsschicht aufgebracht, die vollständig aus einem der genannten Materialien besteht. Ferner ist es möglich, dass eine Facette des Halbleiterkörpers abwechselnd unterschiedliche Schichten aus dem genannten Material aufgebracht werden. Vorzugsweise ist auf alle freiliegenden Stellen der aktiven Zone eine oder mehreren der genannten Passivierungsschichten aufgebracht. Ebenso ist denkbar, dass eine Passivierungsschicht ebenso auf weitere freiliegende Stellen des Halbleiterkörpers, beispielsweise im Bereich eines Strukturierungsgrabens und freiliegende Stellen der ohmschen Kontaktschicht aufgebracht ist.

Es wird darüber hinaus ein Verfahren zur Herstellung eines kantenemittierenden Halbleiterlasers angegeben. Beispielsweise kann mittels des Verfahrens ein kantenemittierender Halbleiterlaser hergestellt werden, wie er in Verbindung mit einem oder mehreren der oben genannten Ausführungsformen beschrieben ist. Das heißt, die für die hier beschriebenen Halbleiterlaser aufgeführten Merkmale sind auch für das hier beschriebene Verfahren offenbart und umgekehrt.

In einem ersten Schritt zur Herstellung eines kantenemittierenden Halbleiterlasers wird ein Halbleiterkörper bereitgestellt, wobei der Halbleiterkörper zumindest eine zur Erzeugung von elektromagnetischer Strahlung geeignete aktive Zone umfasst.

In einem weiteren Schritt wird eine Vielzahl von matrixartig angeordneten Kontaktstellen an eine Außenfläche des Halbleiterkörpers aufgebracht, wobei die Kontaktstellen sowohl in lateraler Richtung als auch in einer zur lateralen Richtung quer verlaufenden Querrichtung voneinander durch Zwischenbereiche beabstandet angeordnet werden.

In einem weiteren Schritt werden zumindest zwei Facetten an der aktiven Zone durch Durchtrennen des Halbleiterkörpers in einzelne kantenemittierende Halbleiterlaser entlang von in Querrichtung verlaufenden Durchtrennungslinien erzeugt, wobei die Durchtrennungslinien nicht durch jeden der Zwischenbereiche verlaufen. Das heißt, dass in lateraler Richtung zumindest ein Zwischenbereich existiert, durch den keine Trennungslinie verläuft und damit an Stellen des Halbleiterkörpers, die in vertikaler Richtung mit einem solchen Zwischenbereich überlappen, der Halbleiterkörper nicht durchtrennt wird.

Vorzugsweise werden die zumindest zwei Facetten mittels Ritzen oder Brechen erzeugt. Das Ritzen erfolgt vorzugsweise mechanisch oder mittels eines fokussierten Laserstrahls. Beim Ritzen werden beispielsweise in vertikaler Richtung Bruchkeime in das Halbleitermaterial gesetzt. Durch einen anschließenden Brechvorgang wird das Halbleitermaterial in einzelne Halbleiterlaser, beispielsweise in Form von Laserbarren, gebrochen und so an den Seitenflächen der Halbleiterlaser Bruchflächen erzeugt. Die Bruchflächen bilden dann die Facetten aus. Alternativ können die zumindest zwei Facetten durch nass- oder trockenchemische Ätzprozesse erzeugt werden. Ist die Facette beispielsweise durch Sägen erzeugt, so kann sie anschließend mittels Polieren oder Schleifen geglättet werden. Vorzugsweise werden zumindest zwei Facetten gebildet, die aneinander gegenüberliegende und bevorzugt planparallele zueinander angeordnete Seitenflächen des Halbleiterkörpers ausbilden, sodass die optische aktive Zone zusammen mit den Facetten einen Resonator ausbildet.

Werden kantenemittierende Halbleiterlaser beispielsweise durch Durchtrennen von Kontaktstellen hergestellt, ist dies jedoch mit dem Nachteil verbunden, dass aufgrund des Vereinzelns durch solche Kontaktstellen beispielsweise das metallische Material der Kontaktstellen zu Metallüberhängen an den Facetten führen kann und damit die Facetten beispielsweise in ihrer Oberflächenbeschaffenheit verschlechtert werden können. Insofern können derartige durch das Vereinzeln einer durchgehenden Kontaktstelle hervorgerufene Schädigungen an den Facetten die optische Ausgangsleistung und/oder eine Lebensdauer des kantenemittierenden Halbleiterlasers beeinträchtigen.

Solche randseitigen Schädigungen können dadurch vermieden werden, dass die Kontaktstellen in lateraler Richtung von den späteren Facetten "zurückgezogen" sind. Dadurch wird zwar an diesen Stellen nicht durch die Kontaktstellen, sondern lediglich durch den Halbleiterkörper durchtrennt, jedoch ist die laterale Ausdehnung eines Halbleiterkörpers bereits vor dem Durchtrennen durch die laterale Ausdehnung der jeweiligen Kontaktstelle festgelegt.

Um nun ein Verfahren anzugeben, bei dem zum einen während des Durchtrennens durch Metallüberhänge der Kontaktstellen keine Schädigungen beispielsweise an den Facetten des Halbleiterkörpers entstehen und gleichzeitig die laterale Ausdehnung eines Halbleiterlasers nicht bereits vor dem Durchtrennen durch die Ausdehnung der Kontaktstellen festgelegt ist, macht das hier beschriebene Verfahren unter anderem von der Idee Gebrauch, eine Vielzahl von matrixartig angeordneten Kontaktstellen an einer Außenfläche des Halbleiterkörpers anzuordnen, wobei die Kontaktstellen sowohl in lateraler Richtung als auch in einer zur lateralen Richtung quer verlaufenden Querrichtung durch Zwischenbereiche beabstandet angeordnet sind. In einem nächsten Schritt werden zumindest zwei Facetten an der aktiven Zone durch Durchtrennen des Halbleiterkörpers in einzelne kantenemittierende Halbleiterlaser entlang von Durchtrennungslinien erzeugt, wobei die Durchtrennungslinien nicht durch sämtliche Zwischenbereiche verlaufen. Mit anderen Worten kann je nach Bedarf der Halbleiterkörper entlang der Durchtrennungslinien durchtrennt werden, wobei zumindest ein aus dem Verfahren hergestellter Halbleiterlaser zumindest zwei Kontaktstellen umfasst. Vorteilhaft ist damit das hier vorgeschlagene Verfahren nicht nur besonders Material schonend, sondern auch individuell an die Bedürfnisse des Benutzers angepasst. Beispielsweise kann so eine Resonatorlänge, welche parallel zur lateralen Richtung verläuft, bei den aus dem Verfahren hergestellten, kantenemittierenden Halbleiterlasern eingestellt werden.

Gemäß zumindest einer Ausführungsform des Verfahrens verlaufen die Durchtrennungslinien durch jeden n-ten Zwischenbereich, wobei n > 1. Beträgt beispielsweise n = 2, so ist denkbar, dass kantenemittierende Halbleiterlaser erzeugt werden, bei denen die Kontaktstellen in lateraler Richtung paarweise angeordnet sind.

Gemäß zumindest einer Ausführungsform des Verfahrens wird vor dem Anbringen der Kontaktstellen auf die Außenfläche des Halbleiterkörpers über die Außenfläche des Halbleiterkörpers im Bereich zumindest eines Zwischenbereichs zumindest eine Ableitstruktur in den Halbleiterkörper eingebracht. Zum Beispiel ist die Ableitstruktur eine Ausnehmung im Halbleiterkörper. Vorteilhaft können durch die Ableitstrukturen zum Beispiel während eines Auflötens der Kontaktstellen auf die Außenfläche des Halbleiterkörpers durch das Auflöten entstehende Luftblasen oder überschlüssiges Lotmaterial von einer Benetzungsfläche zwischen den Kontaktstellen und der Außenfläche weg- oder abgeleitet werden.

Gemäß zumindest einer Ausführungsform weisen die Kontaktstellen einen Abstand in lateraler Richtung von mindestens 15 µm auf. Ein derartiger Abstandsbereich ermöglicht ein Durchtrennen beispielsweise mittels mechanischen Sägens oder mittels eines fokussierten Laserstrahls. Mit anderen Worten ist durch einen derartigen Abstand eine Breite einer Sägespur zwischen den Kontaktstellen einstellbar.

Gemäß zumindest einer Ausführungsform wird vor dem Durchtrennen zumindest ein Graben zwischen in Querrichtung benachbarten Kontaktstellen über die Außenfläche des Halbleiterkörpers eingebracht, wobei im Bereich des Grabens Teile des Halbleiterkörpers zumindest stellenweise vollständig entfernt werden und der Graben die aktive Zone in Querrichtung unterteilt. Beispielsweise verläuft der Graben durchgehend und zusammenhängend in lateraler Richtung. Die Gräben weisen vorzugsweise eine Breite von jeweils wenigstens 30pm auf. Mit anderen Worten bildet der Graben dann ein zusammenhängendes Gebiet aus. Insbesondere weist der zumindest eine Graben eine einer Öffnung des Grabens gegenüberliegende Bodenfläche sowie zwei Seitenflächen auf, welche durch die Bodenfläche miteinander verbunden sind. Sowohl die Seitenflächen als auch die Bodenfläche sind dann vollständig durch den Halbleiterkörper gebildet. Es kann sich bei dem Graben also um eine Ausnehmung im Halbleiterkörper handeln. Vorzugsweise verläuft der Graben kontinuierlich und zusammenhängend in lateraler Richtung. Beispielsweise legt der Graben eine spätere Ausdehnung des kantenemittierenden Halbleiterlasers in Querrichtung, also die Laserbarrenbreite des kantenemittierenden Halbleiterlasers, fest. Mit anderen Worten kann der Graben als eine Markierung zur späteren Durchtrennung dienen. Zum Beispiel wird der Graben mittels Fräsens oder eines trocken- oder nasschemischen Ätzverfahrens in den Halbleiterkörper eingebracht.

Gemäß zumindest einer Ausführungsform wird vor dem Durchtrennen auf freiliegende Stellen des Halbleiterkörpers zumindest stellenweise zumindest eine Passivierungsschicht aufgebracht, die zumindest eines der Materialien Siliziumdioxid, Siliziumnitrid, Titandioxid, Aluminiumdioxid und/oder Silizium enthält. Beispielsweise wird die Passivierungsschicht auf freiliegende Stellen des Halbleiterkörpers im Bereich des Grabens aufgebracht. Ebenso kann die Passivierung vollständig auf alle freiliegenden Stellen des Halbleiterkörpers und/oder der ohmschen Kontaktschicht aufgebracht werden.

Gemäß zumindest einer Ausführungsform wird der Halbleiterkörper entlang des zumindest einen Grabens in einzelne kantenemittierende Halbleiterlaser durchtrennt. Vorteilhaft ermöglicht der Graben neben der bereits angesprochenen Markierungsfunktion ebenso ein vereinfachtes Durchtrennen, da im Bereich des Grabens der Halbleiterkörper in seiner vertikalen Ausdehnung dünner ist und aufgrund der vertikalen Ausdehnung des Grabens nicht durch die aktive Zone durchtrennt werden muss. Dadurch werden durch das Durchtrennen des Halbleiterkörpers hervorgerufene mechanische und/oder thermische Schädigungen an der aktiven Zone vermieden.

Gemäß zumindest einer Ausführungsform wird auf nach dem Durchtrennen des Halbleiterkörpers freiliegende Bruchflächen, zum Beispiel die Facetten der Halbleiterlaser, zumindest stellenweise zumindest eine Passivierungsschicht aufgebracht.

Im Folgenden wird der hier beschriebene kantenemittierende Halbleiterlaser sowie das hier beschriebene Verfahren anhand von Ausführungsbeispielen und der dazugehörigen Figuren näher erläutert.

Die Figuren 1A bis 1C zeigen in einer schematischen Seitenan- und Draufsicht ein Ausführungsbeispiel eines hier beschriebenen kantenemittierenden Halbleiterlasers.

Die Figur 1D zeigt ein schematisches Diagramm einer Stromdichteverteilung innerhalb eines Ausführungsbeispiels eines hier beschriebenen kantenemittierenden Halbleiterlasers.

Die Figuren 2A bis 2E zeigen einzelne Fertigungsschritte in unterschiedlichen Ansichten zur Herstellung eines Ausführungsbeispiels eines hier beschriebenen kantenemittierenden Halbleiterlasers.

In dem Ausführungsbeispiel und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

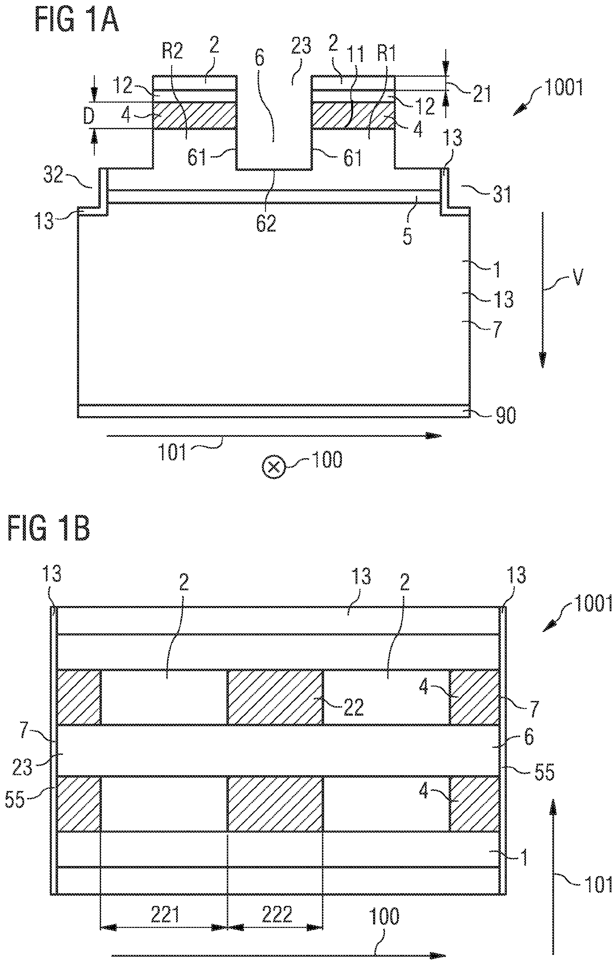

In der Figur 1A ist anhand einer schematischen Seitenansicht in lateraler Richtung 100 ein hier beschriebener kantenemittierender Halbleiterlaser 1001 mit einem Halbleiterkörper 1 dargestellt. Der Halbleiterkörper 1 umfasst eine aktive Zone 5.

Auf eine Außenfläche 11 sind in Form einer 2x2 Matrix vier Kontaktstellen 2 angeordnet. Die Kontaktstellen 2 sind in lateraler Richtung 100 durch Zwischenbereiche 22 in einem lateralen Abstand 222 von 35 µm voneinander beabstandet angeordnet. Ferner sind die Kontaktelemente 2 in einer zur lateralen Richtung 100 quer verlaufenden Querrichtung 101 durch einen Zwischenbereich 23 getrennt. Der kantenemittierende Halbleiterlaser 1001 ist durch die Kontaktelemente 2 und durch einen auf eine den Kontaktelementen 2 abgewandte Oberfläche des Halbleiterkörpers 1 aufgebrachten weiteren elektrischen Kontakt 90 elektrisch kontaktierbar. Zum Beispiel bilden die Kontaktelemente 2 einen Plus- und der weitere elektrische Kontakt 90 einen Minuspol. Unter elektrischer Kontaktierung emittiert die aktive Zone 5 elektromagnetische Strahlung im Bereich von ultraviolettem bis infrarotem Licht.

Ferner weist der kantenemittierende Halbleiterlaser 100 zwei Facetten 7 auf, die sich in lateraler Richtung 100 gegenüberliegen und im Bereich der aktiven Zone 5 einen Laserresonator 55 ausbilden, wobei über eine der Facetten 7 elektromagnetische Strahlung aus dem kantenemittierenden Halbleiterlaser 1001 ausgekoppelt wird.

Zwischen in der Querrichtung 101 benachbarten Kontaktstellen 2 ist ein durchgehend und zusammenhängend in lateraler Richtung 100 verlaufender Strukturierungsgraben 6 eingebracht, dessen Seitenflächen 61 und eine Bodenfläche 62 vollständig durch den Halbleiterkörper 1 gebildet sind. Mittels des Strukturierungsgrabens 6 sind in dem kantenemittierenden Halbleiterlaser 1001 Rippen R1 und R2 gebildet. Mit anderen Worten handelt es sich bei dem kantenemittierenden Halbleiterlaser 1001 um einen Rippen- oder Breitstreifenlaser.

In der Querrichtung 101 sind in den Halbleiterkörper 1 Stufen 31 und 32 eingebracht, die in vertikaler Richtung V die aktive Zone 5 durchbrechen. Die Stufen 31 und 32 verlaufen in lateraler Richtung 100 durchgehend und zusammenhängend und begrenzen daher die aktive Zone 5 in Querrichtung 101. Auf freiliegende Stellen der Stufen 31 und 32 ist vollständig zumindest eine Passivierungsschicht 13 aufgebracht.

Eine ohmsche Kontaktschicht 4 ist auf die Außenfläche 11 im Bereich der Rippen R1 und R2 aufgebracht. Vorliegend enthält die ohmsche Kontaktschicht 4 TiPt oder CrPt. Ferner ist auf in vertikaler Richtung V mit den Kontaktstellen 2 überlappende Bereiche der ohmschen Kontaktschicht 4 eine mit Gold gebildete Benetzungschicht 12 aufgebracht. Vorteilhaft ermöglicht die Benetzungsschicht 12 eine ausreichende Lotbenetzung, sodass die Kontaktstellen 2 mechanisch fest und elektrisch gut kontaktierbar angebracht werden können.

In der Figur 1B ist in einer schematischen Draufsicht der Halbleiterlaser 1001 der Figur 1A gezeigt. Erkennbar sind wiederum die sich in lateraler Richtung 100 gegenüberliegenden Facetten 7, welche zusammen den Laserresonator 55 bilden. Ferner ist auf die Facetten 7 vollständig die Passivierungsschicht 13 aufgebracht, die mit zumindest einem der Materialien Siliziumdioxid, Siliziumnitrid, Titandioxid, Aluminiumdioxid und/oder Silizium gebildet ist.

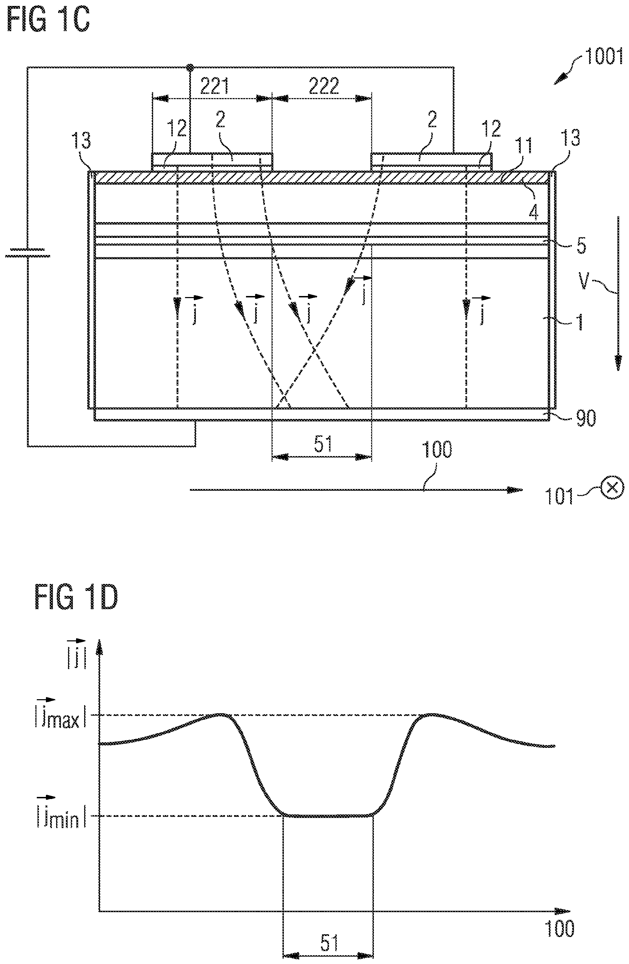

In der Figur 1C ist anhand einer schematischen Seitenansicht in Querrichtung 101 der kantenemittierende Halbleiterlaser 1001 dargestellt. Gezeigt sind Stromdichteführungslinien *̅j̅*̅, entlang derer der elektrische Strom innerhalb des Halbleiterkörpers 1 geführt wird. Erkennbar ist, dass ein in vertikaler Richtung V mit den Kontaktstellen 2 nicht überlappender Bereich 51 der aktiven Zone 5 geringer bestromt wird. Die Bestromungshöhe im Bereich 51 der aktiven Zone 5 hängt beispielsweise von einer Querleitfähigkeit des zwischen der aktiven Zone 5 und den Kontaktstellen 2 angeordneten Halbleitermaterials ab. Vorliegend sind die Kontaktstellen 2 derart angeordnet, dass eine Bestromungsdichte j im Bereich 51 der aktiven Zone 5 zumindest das 0,5-Fache einer maximalen Bestromungsdichte jmax der aktiven Zone 5 beträgt. Der weitere elektrische Kontakt 90 ist in der Figur 1C als eine durchgehende und zusammenhängende Schicht dargestellt. Ebenso ist denkbar, dass der weitere elektrische Kontakt 90 in vertikaler Richtung V mit den Kontaktstellen 2 überlappt. Der weitere elektrische Kontakt 90 kann dann identisch zu den Kontaktelementen 2 aufgebaut und mit einzelnen, jeweils benachbarten Kontaktelementen gebildet sein.

Die Figur 1D zeigt ein schematisches Diagramm einer Stromdichteverteilung innerhalb des Halbleiterkörpers 1 entlang der lateralen Richtung 100 des kantenemittierenden Halbleiterlasers 1001. Erkennbar ist, dass in vertikaler Richtung V direkt unterhalb der Kontaktelemente 2 die aktive Zone 5 mit der maximalen Bestromungsdichte jmax bestromt wird. In lateraler Richtung 100 innerhalb des Bereichs 51 der aktiven Zone 5 weist die Bestromungsdichte j ein plateauartiges Minimum jmin auf, das die Hälfte der maximalen Bestromungdichte jmax der aktiven Zone 5 beträgt. Mit anderen Worten sind Bereiche der aktiven Zone 5, die sich in vertikaler Richtung V direkt unterhalb der Kontaktelemente 2 befinden, am besten bestromt.

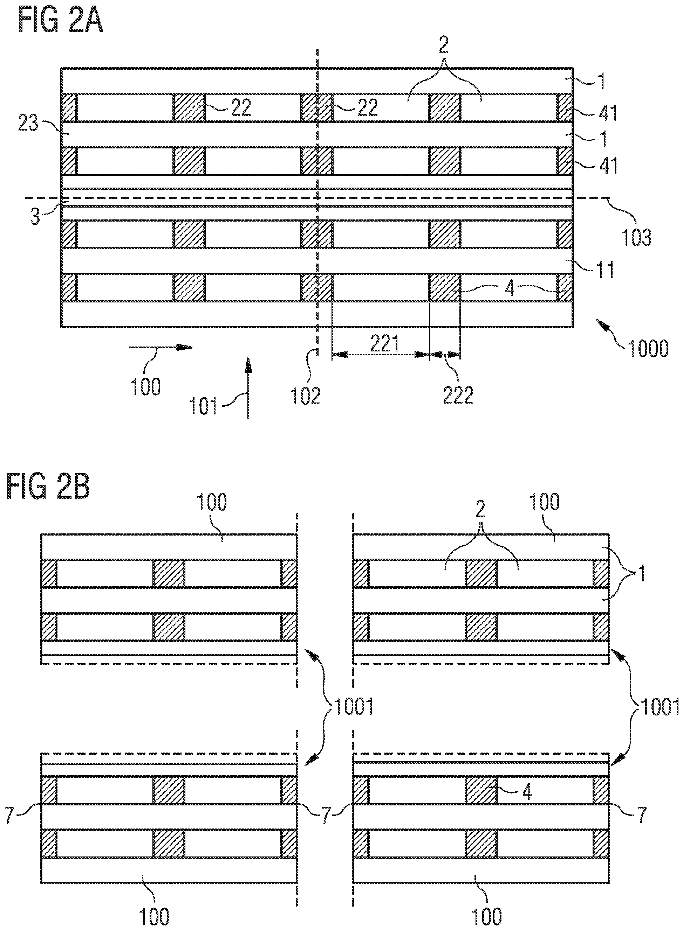

In Verbindung mit den Figuren 2A bis 2E wird anhand schematischer Ansichten ein hier beschriebenes Verfahren zur Herstellung des kantenemittierenden Halbleiterlasers 1001 näher erläutert.

Die Figur 2A zeigt in einer schematischen Draufsicht einen Verbund 1000 bestehend aus dem Halbleiterkörper 1 sowie den auf die Außenfläche 11 aufgebrachten matrixartig angeordneten Kontaktstellen 2. Vorliegend sind die Kontaktstellen 2 gitternetzartig angeordnet, wobei jede der Kontaktstellen 2 durch die Zwischenbereiche 22 in lateraler Richtung 100 und in der Querrichtung 101 durch die Zwischenbereiche 23 beabstandet voneinander angeordnet sind. In vertikaler Richtung V zwischen den Kontaktstellen 2 und dem Halbleiterkörper 1 ist eine ohmsche Kontaktschicht 4 angeordnet, die durch einzelne in Querrichtung 101 durch jeweils einen Zwischenbereich 23 voneinander getrennte Einzelstreifen 41 gebildet ist, welche jeweils in lateraler Richtung 100 durchgehend und zusammenhängend verlaufen. Mit anderen Worten sind in vertikaler Richtung V die Kontaktstellen 2 mit der ohmschen Kontaktschicht 4 stellenweise deckgleich. Die Gesamtdicke D gebildet mit der Dicke der ohmschen Kontaktschicht 4 zusammen mit der Dicke der Benetzungsschicht 12 beträgt vorliegend höchstens die Hälfte einer maximalen vertikalen Ausdehnung 21 der Kontaktstellen 2.

Ferner sind in der Figur 2A zwei Trennungslinien 102 und 103 dargestellt. Die Trennungslinie 102 verläuft durchgehend in Querrichtung 101 durch die Zwischenbereiche 22. Die Trennungslinie 103 verläuft innerhalb und entlang eines Grabens 3. Der Graben 3 verläuft in der lateralen Richtung 100 durchgehend und zusammenhängend und durchbricht in vertikaler Richtung V die aktive Zone 5 des Halbleiterkörpers 1. Der Graben 3 weist eine Breite von vorzugsweise wenigstens 30 µm auf.

In der Figur 2B ist ein weiterer Schritt dargestellt, bei dem entlang der Trennungslinien 102 und 103 der Halbleiterkörper 1 in einzelne kantenemittierende Halbleiterlaser 1001 durchtrennt wird. Durch das Durchtrennen hergestellte, kantenemittierende Halbleiterlaser 1001 weisen vier matrixartig angeordnete Kontaktstellen 2 auf. Das heißt, auf der Außenfläche 11 sind sowohl in lateraler Richtung 100 als auch in Querrichtung 101 jeweils zwei voneinander beabstandet angeordnete Kontaktstellen 2 angeordnet. Durch das Vereinzeln sind jeweils zwei sich gegenüberliegende, planparallele Facetten 7 gebildet, die den Laserresonator 55 bilden. Vorteilhaft wird durch eine derart im Vergleich zu den Kontaktstellen "dünne" Gesamtdicke der ohmschen Kontaktschicht 4 mit der Benetzungsschicht 12 vermieden, dass durch das Durchtrennen der ohmschen Kontaktschicht 4 und der Benetzungsschicht 12 beispielsweise entstehende metallische Reste Störungen an den Facetten 7 hervorrufen.

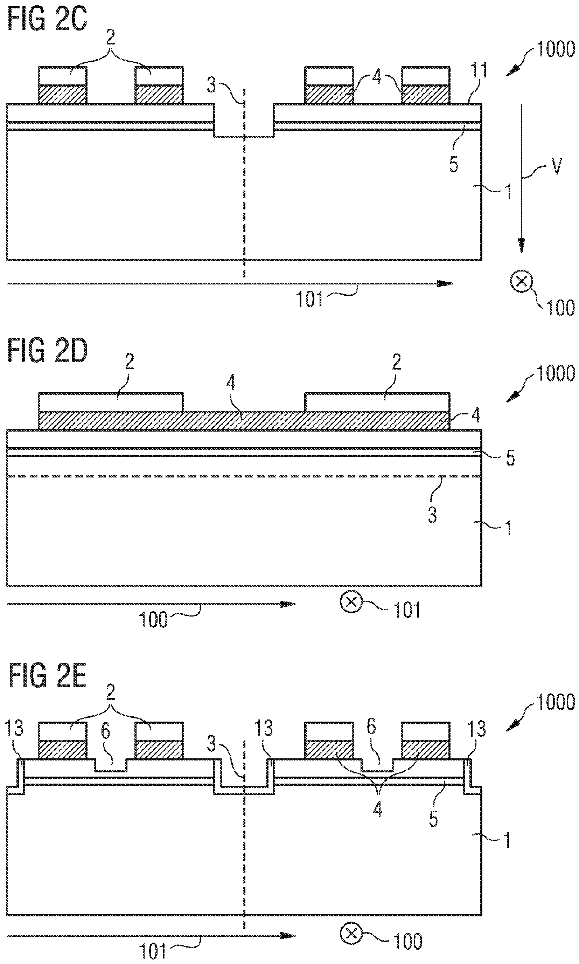

Die Figur 2C zeigt den Verbund 1000 der Figur 1A in einer schematischen Seitenansicht in Richtung der lateralen Richtung 100. Zwischen den in Querrichtung 101 angeordneten Kontaktstellen 2 ist in den Halbleiterkörper 1 der Graben 3 eingebracht, wobei in der Figur 2C erkennbar ist, dass der Graben 3 die aktive Zone 5 in Querrichtung 101 unterteilt.

Die Figur 2D zeigt den Verbund 1000 in Richtung der Querrichtung 101. Wiederum erkennbar sind die in lateraler Richtung 100 voneinander beabstandeten Kontaktelemente 2 sowie die in lateraler Richtung 100 durchgehende aktive Zone 5.

In der Figur 2E ist der Verbund 1000 ebenfalls aus der lateralen Richtung 100 gezeigt, bei dem jedoch zusätzlich zwischen den paarweise benachbarten Kontaktstellen 2 in den Halbleiterkörper 1 die Strukturierungsgräben 6 eingebracht sind, welche jedoch nicht bis zur aktiven Zone 5 reichen. Mit anderen Worten unterteilen die Strukturierungsgräben 6 die aktive Zone 5 nicht. Mittels der Strukturierungsgräben 6 sind nach dem Durchtrennen des Halbleiterkörpers 1 Rippenlaser ausgebildet. Ferner ist auf freie Stellen des Halbleiterkörpers 1 im Bereich des Grabens 3 vollständig eine Passivierungsschicht 13 aufgebracht. Ebenso kann die Passivierungsschicht 13 auf weitere freie Stellen des Halbleiterkörpers 1 aufgebracht werden. Nach dem Durchtrennen des Halbleiterkörpers 1 entlang des Grabens 3 sind zum Beispiel die Stufen 31 und 32 in jedem Halbleiterlaser 1 ausgebildet.

## Patentansprüche

1. Kantenemittierender Halbleiterlaser (1001), mit:
- einem Halbleiterkörper (1), der zumindest eine zur Erzeugung von elektromagnetischer Strahlung geeignete aktive Zone (5) umfasst;
- zumindest zwei in lateraler Richtung (100) voneinander durch zumindest einen Zwischenbereich (22) beabstandete Kontaktstellen (2), die auf einer Außenfläche (11) des Halbleiterkörpers (1) angebracht sind;
- zumindest zwei Facetten (7) an der aktiven Zone (5), die einen Resonator (55) bilden und sich in lateraler Richtung (100) gegenüber liegen; wobei
- in vertikaler Richtung (V) zwischen den Kontaktstellen (2) und dem Halbleiterkörper (1) zumindest stellenweise eine ohmsche Kontaktschicht (4) mit einem metallischen Material angeordnet ist, wobei die ohmsche Kontaktschicht (4) als zumindest ein Einzelstreifen (41) gebildet ist, welcher in lateraler Richtung (100) durchgehend und zusammenhängend verläuft, sodass der Einzelstreifen (41) über den zumindest einen Zwischenbereich (22) hinweg verläuft und die Kontaktstellen (2) und die ohmsche Kontaktschicht (4) in vertikaler Richtung (V) stellenweise deckungsgleich sind.

2. Kantenemittierender Halbleiterlaser (1001) nach dem vorhergehenden Anspruch,
der eine Vielzahl von matrixartig angeordneten Kontaktstellen (2) aufweist, die auf der Außenfläche (11) des Halbleiterkörpers (1) angebracht sind und sowohl in lateraler Richtung (100) als auch in einer zur lateralen Richtung (100) quer verlaufenden Querrichtung (101) jeweils durch Zwischenbereiche (22, 23) voneinander beabstandet angeordnet sind.

3. Kantenemittierender Halbleiterlaser (1001) nach Anspruch 2,
bei dem zumindest ein Strukturierungsgraben (6) im Bereich zwischen in Querrichtung (101) benachbarten Kontaktstellen (2) in den Halbleiterkörper (1) eingebracht ist, wobei im Bereich des Strukturierungsgrabens (6) Teile des Halbleiterkörpers (1) zumindest stellenweise vollständig entfernt sind, wobei der Strukturierungsgraben (6) in vertikaler Richtung nicht bis zur aktiven Zone (5) reicht.

4. Kantenemittierender Halbleiterlaser (1001) nach einem der vorhergehenden Ansprüche,
bei dem in vertikaler Richtung (V) direkt unterhalb der Kontaktelemente (2) die aktive Zone (5) eine maximale Bestromungsdichte jmax aufweist und ein in vertikaler Richtung mit den Kontaktstellen (2) nicht überlappender Bereich (51) der aktiven Zone (5) zumindest das 0,3-Fache der maximalen Bestromungsdichte jmax der aktiven Zone (5) aufweist, wobei sich der nicht überlappende Bereich (51) zwischen zumindest zwei benachbarten Kontaktstellen (2) befindet.

5. Kantenemittierender Halbleiterlaser (1001) nach einem der vorhergehenden Ansprüche,
bei dem ein Abstand (222) zweier in lateraler Richtung (100) benachbarter Kontaktstellen (2) höchstens eine maximale laterale Ausdehnung (221) der Kontaktstellen (2) ist.

6. Kantenemittierender Halbleiterlaser (1001) nach einem der vorhergehenden Ansprüche,
bei dem die ohmsche Kontaktschicht (4) zumindest eines der folgenden Materialien enthält: Ti, Pt, Cr, Pd.

7. Kantenemittierender Halbleiterlaser (1001) nach einem der vorhergehenden Ansprüche,
bei dem auf die ohmsche Kontaktschicht (4) zumindest stellenweise eine Benetzungsschicht (12) aufgebracht ist.

8. Kantenemittierender Halbleiterlaser (1001) nach einem der vorhergehenden Ansprüche,
bei dem auf zumindest eine Facette (7) zumindest stellenweise zumindest eine Passivierungsschicht (13) aufgebracht ist, die zumindest eines der folgenden Materialien enthält: SiO2, SiN, TiO2, Al2O3, Si.

9. Verfahren zur Herstellung eines kantenemittierenden Halbleiterlasers (1001) mit zumindest den folgenden Schritten:
- Bereitstellen eines Halbleiterkörpers (1), wobei der Halbleiterkörper (1) zumindest eine zur Erzeugung von elektromagnetischer Strahlung geeignete aktive Zone (5) umfasst;
- Aufbringen einer Vielzahl von matrixartig angeordneten Kontaktstellen (2) an einer Außenfläche (11) des Halbleiterkörpers (1), wobei die Kontaktstellen (2) sowohl in lateraler Richtung (100) als auch in einer zur lateralen Richtung (100) quer verlaufenden Querrichtung (101) voneinander durch Zwischenbereiche (22, 23) beabstandet angeordnet werden, wobei in vertikaler Richtung (V) zwischen den Kontaktstellen (2) und dem Halbleiterkörper (1) zumindest stellenweise eine ohmsche Kontaktschicht (4) mit einem metallischen Material angeordnet ist und wobei die ohmsche Kontaktschicht (4) als zumindest ein Einzelstreifen (41) gebildet ist, welcher in lateraler Richtung (100) durchgehend und zusammenhängend verläuft, sodass der Einzelstreifen (41) über den zumindest einen Zwischenbereich (22) hinweg verläuft und die Kontaktstellen (2) und die ohmsche Kontaktschicht (4) in vertikaler Richtung (V) stellenweise deckungsgleich sind;
- Erzeugen von zumindest zwei Facetten (7) an der aktiven Zone (5) durch Durchtrennen des Halbleiterkörpers (1) in einzelne kantenemittierende Halbleiterlaser (1001) entlang von in Querrichtung (101) verlaufenden Durchtrennungslinien (102), wobei die Durchtrennungslinien (102) nicht durch jeden der Zwischenbereiche (22) verlaufen.

10. Verfahren nach Anspruch 9,
bei dem die Durchtrennungslinien (102) durch jeden n-ten Zwischenbereich (22) verlaufen, wobei n > 1.

11. Verfahren nach einem der Ansprüche 9 oder 10,
bei dem die Kontaktstellen (2) in lateraler Richtung (100) einen Abstand von mindestens 15 µm aufweisen.

12. Verfahren nach einem der Ansprüche 9 bis 11,
bei dem vor dem Durchtrennen zwischen in Querrichtung (101) benachbarten Kontaktstellen (2) zumindest ein Graben (3) über die Außenfläche (11) des Halbleiterkörpers (1) eingebracht wird, wobei im Bereich des Grabens (3) Teile des Halbleiterkörpers (1) zumindest stellenweise vollständig entfernt werden und der Graben (3) die aktive Zone (5) in Querrichtung (101) unterteilt.

13. Verfahren nach Anspruch 12,
bei dem der Halbleiterkörper (1) entlang des zumindest einen Grabens (3) in einzelne kantenemittierende Halbleiterlaser (100) durchtrennt wird.

14. Verfahren nach einem der Ansprüche 9 bis 13,
wobei ein kantenemittierender Halbleiterlaser (1001) gemäß einem der Ansprüche 1 bis 9 hergestellt wird.

## Claims

1. Edge-emitting semiconductor laser (1001), with:
- a semiconductor body (1) comprising at least one active zone (5) suitable for generating electromagnetic radiation;
- at least two contact points (2) spaced from each other in a lateral direction (100) by at least one intermediate region (22) and mounted on an outer surface (11) of said semiconductor body (1);
- at least two facets (7) on the active zone (5) forming a resonator (55) and facing each other in the lateral direction (100); wherein
- in the vertical direction (V) between the contact points (2) and the semiconductor body (1) at least in places an ohmic contact layer (4) with a metallic material is arranged, the ohmic contact layer (4) being formed as at least one individual strip (41), which extends continuously and contiguously in the lateral direction (100) so that the individual strip (41) extends over the at least one intermediate region (22) and the contact points (2) and the ohmic contact layer (4) are congruent in places in the vertical direction (V).

2. Edge-emitting semiconductor laser (1001) according to the preceding claim,
which has a multiplicity of contact points (2) which are arranged in a matrix-like manner, are mounted on the outer surface (11) of the semiconductor body (1) and are arranged spaced apart from one another both in the lateral direction (100) and in a transverse direction (101) running transversely to the lateral direction (100) by intermediate regions (22, 23) in each case.

3. Edge-emitting semiconductor laser (1001) according to claim 2,
in which at least one structuring trench (6) is introduced into the semiconductor body (1) in the region between contact points (2) adjacent in the transverse direction (101), parts of the semiconductor body (1) being completely removed at least in places in the region of the structuring trench (6), the structuring trench (6) not reaching as far as the active zone (5) in the vertical direction.

4. Edge-emitting semiconductor laser (1001) according to one of the preceding claims,
in which in the vertical direction (V) directly below the contact elements (2) the active zone (5) has a maximum current density jmax and a region (51) of the active zone (5) which does not overlap in the vertical direction with the contact points (2) has at least 0.3 times the maximum current density jmax of the active zone (5), the non-overlapping region (51) being located between at least two adjacent contact points (2).

5. Edge-emitting semiconductor laser (1001) according to one of the preceding claims,
in which a distance (222) between two contact points (2) adjacent in the lateral direction (100) is at most a maximum lateral extent (221) of the contact points (2).

6. Edge-emitting semiconductor laser (1001) according to one of the preceding claims,
in which the ohmic contact layer (4) contains at least one of the following materials: Ti, Pt, Cr, Pd.

7. Edge-emitting semiconductor laser (1001) according to any of the preceding claims,
in which a wetting layer (12) is applied at least in places to the ohmic contact layer (4).

8. Edge-emitting semiconductor laser (1001) according to one of the preceding claims,
in which at least one passivation layer (13) which contains at least one of the following materials is applied at least in places to at least one facet (7): SiO2, SiN, TiO2, Al2O3, Si.

9. A method of manufacturing an edge-emitting semiconductor laser (1001) comprising at least the following steps:
- providing a semiconductor body (1), said semiconductor body (1) comprising at least one active zone (5) suitable for generating electromagnetic radiation;
- applying of a plurality of contact points (2) arranged in a matrix-like manner to an outer surface (11) of the semiconductor body (1), the contact points (2) being arranged spaced apart from one another both in the lateral direction (100) and in a transverse direction (101) running transversely to the lateral direction (100) by intermediate regions (22, 23), wherein in the vertical direction (V) between the contact points (2) and the semiconductor body (1) at least in places an ohmic contact layer (4) with a metallic material is arranged and wherein the ohmic contact layer (4) is formed as at least one individual strip (41), which extends continuously and contiguously in the lateral direction (100) so that the individual strip (41) extends over the at least one intermediate region (22) and the contact points (2) and the ohmic contact layer (4) are congruent in places in the vertical direction (V);
- generating at least two facets (7) on the active zone (5) by severing the semiconductor body (1) into individual edge-emitting semiconductor lasers (1001) along severance lines (102) extending in the transverse direction (101), the severance lines (102) not extending through each of the intermediate regions (22).

10. Method according to claim 9,
in which the severance lines (102) extend through each n-th intermediate region (22), where n > 1.

11. Method according to any of claims 9 or 10,
in which the contact points (2) have a distance of at least 15 µm in the lateral direction (100).

12. Method according to any of claims 9 to 11,
in which at least one trench (3) is introduced over the outer surface (11) of the semiconductor body (1) before severing between contact points (2) adjacent in the transverse direction (101), parts of the semiconductor body (1) being completely removed at least in places in the region of the trench (3), and the trench (3) subdividing the active zone (5) in the transverse direction (101).

13. Method according to claim 12,
in which the semiconductor body (1) is severed along the at least one trench (3) into individual edge-emitting semiconductor lasers (100).

14. Method according to one of claims 9 to 13,
wherein an edge-emitting semiconductor laser (1001) according to any one of claims 1 to 9 is manufactured.

## Revendications

1. Laser à semi-conducteurs à émission latérale (1001), doté de :
- un corps semi-conducteur (1) qui comprend au moins une zone active (5) susceptible de générer un rayonnement électromagnétique ;
- au moins deux points de contact (2) espacés l'un de l'autre dans le sens latéral (100) par au moins une zone intermédiaire (22), lesquels points de contact sont disposés sur une face extérieure (11) du corps semi-conducteur (1) ;
- au moins deux facettes (7) sur la zone active (5), lesquelles constituent un résonateur (55) et sont en vis-à-vis l'une par rapport à l'autre dans le sens latéral (100) ;
- une couche de contact (4) ohmique étant agencée avec un matériau métallique au moins partiellement dans le sens vertical (V) entre les points de contact (2) et le corps semi-conducteur (1), ladite couche de contact (4) ohmique étant constituée au moins en tant qu'une bande unique (41) qui est continue et consécutive dans le sens latéral (100), de sorte que ladite bande unique (41) passe au moins par-dessus ladite au moins une zone intermédiaire (22) et que les points de contact (2) et la couche de contact (4) ohmique coïncident partiellement dans le sens vertical (V).

2. Laser semi-conducteur à émission latérale (1001) selon la revendication précédente,
qui présente une pluralité de points de contact (2) agencés en forme de matrice, lesquels points de contact sont disposés sur la face extérieure (11) du corps semi-conducteur (1) et sont agencés espacés les uns des autres respectivement par des zones intermédiaires (22, 23) aussi bien dans le sens latéral (100) que dans un sens transversal (101) se trouvant à la transversale du sens latéral (100).

3. Laser semi-conducteur à émission latérale (1001) selon la revendication 2,
dans lequel au moins un fossé de structuration (6) est aménagé dans le corps semi-conducteur (1) dans la zone située entre des points de contact (2) voisins dans le sens transversal (101), des pièces du corps semi-conducteur (1) étant au moins partiellement, dans la zone du fossé de structuration (6), retirées en entier, ledit fossé de structuration (6) n'atteignant pas la zone active (5) dans le sens vertical.

4. Laser semi-conducteur à émission latérale (1001) selon l'une quelconque des revendications précédentes,
dans lequel la zone active (5) présente, dans le sens vertical (V), directement en dessous des éléments de contact (2), une densité de passage de courant maximale jmax, et une zone (51) de la zone active (5) ne chevauchant pas les points de contact (2) dans le sens vertical, présente au moins 0,3 fois la densité de passage de courant maximale jmax de la zone active (5), la zone (51) non chevauchante se trouvant entre au moins deux points de contact (2) voisins.

5. Laser semi-conducteur à émission latérale (1001) selon l'une quelconque des revendications précédentes,
dans lequel une distance (222) entre deux points de contact (2) voisins dans le sens latéral (100) est au plus une extension (221) latérale maximum des points de contact (2).

6. Laser semi-conducteur à émission latérale (1001) selon l'une quelconque des revendications précédentes,
dans lequel la couche de contact (4) ohmique contient au moins un des matériaux suivants : Ti, Pt, Cr, Pd.

7. Laser semi-conducteur à émission latérale (1001) selon l'une quelconque des revendications précédentes,
dans lequel une couche d'humectage (12) est appliquée au moins partiellement sur la couche de contact (4) ohmique.

8. Laser semi-conducteur à émission latérale (1001) selon l'une quelconque des revendications précédentes,
dans lequel au moins une couche de passivation (13) est appliquée au moins partiellement sur au moins une facette (7), ladite couche de passivation contenant au moins un des matériaux suivants : SiO2, SiN, TiO2, Al2O3, Si.

9. Procédé de fabrication d'un laser semi-conducteur à émission latérale (1001) avec au moins les étapes suivantes :
- fourniture d'un corps semi-conducteur (1), lequel corps semi-conducteur (1) comprenant au moins une zone active (5) susceptible de générer un rayonnement électromagnétique ;
- application d'une pluralité de points de contact (2) agencés en forme de matrice sur une face extérieure (11) du corps semi-conducteur (1), les points de contact (2) étant agencés espacés les uns des autres par des zones intermédiaires (22, 23) aussi bien dans le sens latéral (100) que dans un sens transversal (101) se trouvant à la transversale du sens latéral (100), une couche de contact (4) ohmique étant agencée avec un matériau métallique au moins partiellement dans le sens vertical (V) entre les points de contact (2) et le corps semi-conducteur (1), et la couche de contact (4) ohmique étant constituée au moins en tant que bande unique (41) qui est continue et consécutive dans le sens latéral (100), de sorte que ladite bande unique (41) passe par-dessus ladite au moins une zone intermédiaire (22), et les points de contact (2) et la couche de contact (4) ohmique coïncident partiellement dans le sens vertical (V) ;
- génération d'au moins deux facettes (7) sur la zone active (5) par sectionnement du corps semi-conducteur (1) en plusieurs lasers semi-conducteurs individuels à émission latérale (1001) le long de lignes de sectionnement (102) s'étendant dans le sens transversal (101), lesdites lignes de sectionnement (102) ne passant pas par chacune des zones intermédiaires (22).

10. Procédé selon la revendication 9,
dans lequel les lignes de sectionnement (102) passent par chaque n^{ème} zone intermédiaire (22), où n > 1.

11. Procédé selon l'une quelconque des revendications 9 ou 10,
dans lequel les points de contact (2) présentent, dans le sens latéral (100), une distance d'au moins 15 µm.

12. Procédé selon l'une quelconque des revendications 9 à 11,
dans lequel, avant le sectionnement entre des points de contact (2) voisins dans le sens transversal (101), au moins un fossé (3) est aménagé par le biais de la face extérieure (11) du corps semi-conducteur (1), dans la zone du fossé (3) des pièces du corps semi-conducteur (1) étant au moins partiellement retirées en entier, et le fossé (3) divisant la zone active (5) dans le sens transversal (101).

13. Procédé selon la revendication 12,
dans lequel le corps semi-conducteur (1) est sectionné le long dudit au moins un fossé (3) en plusieurs lasers semi-conducteurs à émission latérale (100) individuels.

14. Procédé selon l'une quelconque des revendications 9 à 13, un laser semi-conducteur à émission latérale (1001) étant fabriqué selon l'une quelconque des revendications 1 à 9.
